# EUROPÄISCHE PATENTSCHRIFT

(11) **EP 2 984 673 B1**
(45) Veröffentlichungstag und Bekanntmachung des Hinweises auf die Patenterteilung: **11.03.2020**
(21) Anmeldenummer: 14717412.2
(22) Anmeldetag: 07.04.2014
(51) Int. Cl.: H01J 37/34, C23C 14/34

(54) **ZENTRIERUNG EINER PLATTE IN EINER HALTERUNG SOWOHL BEI RAUM- ALS AUCH BEI HÖHEREN TEMPERATUREN**
CENTERING OF A PLATE IN A HOLDER BOTH AT ROOM TEMPERATURES AND AT HIGHER TEMPERATURES
CENTRAGE D'UNE PLAQUE DANS UN SUPPORT TANT À TEMPÉRATURE AMBIANTE QU'À DES TEMPÉRATURES PLUS ÉLEVÉES

(30) Priorität: 08.04.2013 US 201361809524 P
(43) Veröffentlichungstag der Anmeldung: 17.02.2016
(73) Patentinhaber: Oerlikon Surface Solutions AG, Pfäffikon, 8808 Pfäffikon (CH)
(72) Erfinder: KERSCHBAUMER, Joerg, A-6800 Feldkirch (AT)
(74) Vertreter: Misselhorn, Hein-Martin
(86) Internationale Anmeldenummer: PCT/EP2014/000928
(87) Internationale Veröffentlichungsnummer: WO 2014/166621

(56) Entgegenhaltungen:
- EP-A1- 0 393 344
- EP-A1- 0 512 456
- EP-A1- 1 106 715
- JP-A- 2003 226 967
- JP-A- 2010 116 605

## Beschreibung

Die vorliegende Erfindung betrifft ein System umfassend eine Platte mit Halterung, beim dem die Platte in der Halterung sowohl bei Raum- als auch bei höheren Temperaturen unabhängig von der Wärmeausdehnung der Platte und der Halterung zentriert ist, und die Platte sich in der Halterung bei höheren Temperaturen frei ausdehnen kann.

### Stand der Technik

Für die Herstellung von Beschichtungen werden heutzutage unter anderem Sputterund Arc-Prozesse eingesetzt, die zu den sogenannten PVD-Prozessen gehören (PVD: Physical Vapor Deposition). Dabei werden Targets zerstäubt bzw. verdampft. Bei diesen Prozessen werden die Targets heiss und müssen gekühlt werden.

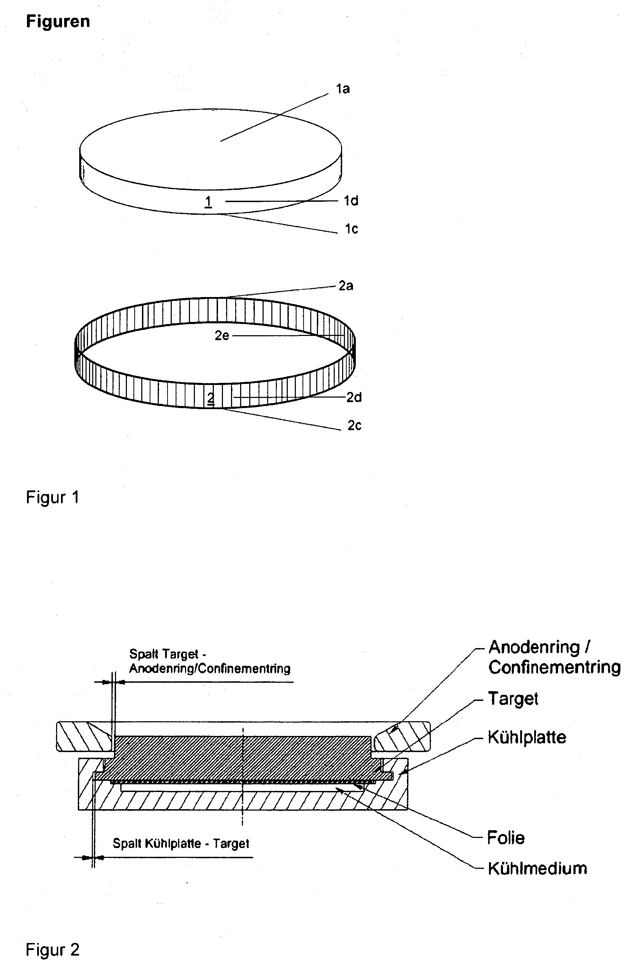

Die Kühlung erfolgt dabei gemäss dem Stand der Technik zum Beispiel über eine sogenannte Kühlplatte des Typs Folienkühlplatte, die das Target an dessen Rückseite kühlt, wie es in der Figur 2 gezeigt ist. Durch den Druck des Kühlmediums wird die Folie an das Target gepresst und dadurch ein guter Wärmeübergang von Kühlmedium zum Target geschaffen.

Abhängig vom Leistungseintrag, der Wärmeabfuhr über die Kühlplatte und der Wärmeleitfähigkeit des Targetmaterials werden die Targets unterschiedlich heiss und dehnen sich entsprechend ihres Längenausdehnungskoeffizienten aus. Das Target muss sich dabei frei auf der Kühlplatte ausdehnen können, damit es nicht zerstört wird.

Prozesstechnisch wichtig ist, dass sich das auf der Kühlplatte liegende Target konzentrisch zur Kühlplattenachse ausdehnt, damit während des gesamten Betriebs ein konzentrischer Spalt zwischen Target und den umgebenden Bauteilen oder dem umgebenden Bauteil gewährleistet werden kann. Im Besonderen ist es sehr wichtig, dass sich das Target zentriert zur Kühlplattenachse ausdehnt, um Kurzschlüsse zu vermeiden, die auftreten können, wenn beispielsweise das Target als Kathode betrieben wird und um das Target herum ein Anodenring angeordnet ist, der auf anderem elektrischen Potential liegt, wie es beispielweise in der Figur 2 gezeigt ist.

Wenn das Target nicht richtig zentriert ist, dehnt sich das Target nicht konzentrisch genug aus. Infolgedessen kann es zum elektrischen Kurzschluss zwischen Anodenring und ausgedehntem Target kommen.

Im vorliegenden Beispiel wird die Position des Targets relativ zum Anodenring durch dessen Anordnung auf der Kühlplatte bestimmt. Bei einem kleinen Spalt zwischen Kühlplatte und Target ist die Position des Targets ausreichend bestimmt und es kommt nicht zum Kontakt zwischen Target und Anode. Durch diesen kleinen Spalt ist allerdings die mögliche Ausdehnung des Targets stark eingeschränkt. Somit wird die maximal zulässige Targettemperatur bzw. Einsatztemperatur vorgegeben und dadurch die maximal zulässige Sputterleistung begrenzt. Je kleiner der Spalt, desto geringer ist somit die zulässige Sputterleistung.

Bei grösserem Spalt liegt das Target in der Regel zu exzentrisch auf der Kühlplatte. Zudem werden durch die exzentrische Auflage die mechanischen Spannungen im Target beim Einsatz von Folienkühlplatten ungleichmässig. Je nach Targetmaterial kann dies zum Überschreiten der zulässigen mechanischen Spannungen führen.

JP 2003 226967 A beschreibt ein Target für PVD mit Halterung, wobei das Target mittels mehrerer Distanzstücke, die sich in entsprechende Einformungen der Halterung einpassen, gehalten wird, wobei die Platte auch bei wechselnden Temperaturen in der Halterung stets zentriert platziert ist. Die Konstruktion löst das Problem der Verspannung von herkömmlichen Targets durch die starke Erwärmung während des Sputterings.

In EP 1106715 A1 wird eine Halterung für einen Shadow-Ring mit Ausformungen und entsprechenden Einformungen in der Halterung zur Zentrierung des Rings trotz thermischer Ausdehnung beschrieben.

### Aufgabe der vorliegenden Erfindung

Es ist Aufgabe der vorliegenden Erfindung, ein System Platte-Aufnahmevorrichtung bereitzustellen, das es ermöglicht, eine Platte in einer Aufnahmevorrichtung unabhängig von der Temperatur des Systems zentriert zu halten, wobei die Platte sich in der Aufnahmevorrichtung so frei ausdehnen darf, dass sie während des Ausdehnungsprozesses nicht zerstört wird.

### Beschreibung der vorliegenden Erfindung

Die Aufgabe der vorliegenden Erfindung wird dadurch gelöst, indem ein System Platte-Halterung, wie im Anspruch 1 beschrieben, bereitgestellt wird.

Das System gemäss der vorliegenden Erfindung umfasst eine Platte und eine Halterung, wobei die Platte eine Oberfläche mit einem äusseren Plattenrand aufweist und das Material der Platte einen ersten thermischen Expansionskoeffizienten, besitzt und die Halterung eine Öffnung aufweist welche durch eine innere Halterungsberandung begrenzt ist und das Material der Halterung einen zweiten thermischen Expansionskoeffizienten besitzt und der erste thermische Expansionskoeffizient grösser als der zweite thermische Expansionskoeffizient ist,
wobei
- bei Raumtemperatur der Umfang der Öffnung der Halterung grösser als der Umfang der Oberfläche der Platte ist, wodurch bei zentrierter Position der Platte ein Spalt mit einer definierten Spaltbreite S zwischen Plattenrand und innerer Halterungsberandung vorliegt
- der Plattenrand eine oder mehrere Ausformungen umfasst, welche sich entlang der radialen Richtung zur Plattenrandoberfläche erstrecken und in korrespondierende Einformungen der Halterungsberandung eingreifen und/oder der Plattenrand eine oder mehrere Einformungen umfasst, welche sich entlang der radialen Richtung zur Plattenrandoberfläche erstrecken und korrespondierende Ausformungen der Halterungsberandung in diese eingreifen
- wobei das System Platte - Halterung zumindest drei solcher ineinander greifender Einformungs-Ausformungspaare umfasst und wobei jede Einformung und jede Ausformung eine jeweilige Länge in radialer Richtung zur Plattenrandoberfläche mit jeweiliger Breite aufweist, und jeweils die Breite einer Einformung grösser ist als die Breite der korrespondierenden Ausformung, für jedes Einformungs-Ausformungspaar bei Raumtemperatur der kleinste Breitenunterschied sp zwischen Einformung und Ausformung kleiner als die oben genannte Spaltbreite S ist, in der radialen Richtung die kleinste Spaltbreite zwischen Einformung und Ausformung grösser als der oben genannte kleinste Breitenunterschied sp ist, vorzugsweise mindestens gleich gross wie die oben genannte Spaltbreite S ist und dadurch erreicht wird, dass sowohl bei Raumtemperatur als auch bei höheren Temperaturen, die Platte immer zentriert in der Halterung verankert ist, da die Einformungs-Ausformungspaare als Führungsschienen wirken.

Unter "radialer Richtung" ist im Sinne der vorliegenden Beschreibung definitionsgemäss folgendes zu verstehen: Wird die Platte an einer Achse, welche senkrecht auf die Plattenoberfläche steht und durch deren Schwerpunkt geht, fixiert, so ist die radiale Richtung an einer Stelle des äusseren Plattenrandes jeweils diejenige Richtung, in die sich bei einer Temperaturerhöhung die Stelle des äusseren Plattenrandes bewegt. Bei einer scheibenförmigen Platte mit kreisförmigem Rand ist dies die senkrechte auf den Plattenrand weg vom Kreismittelpunkt.

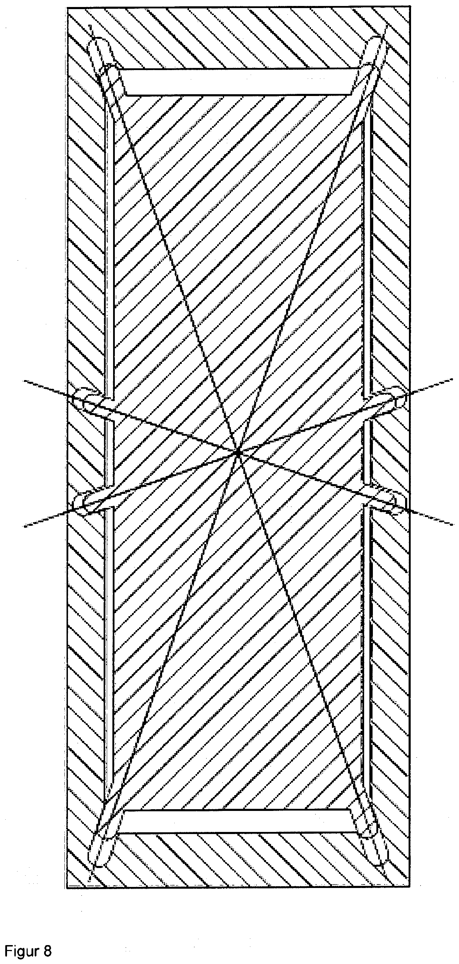

In Figur 8 ist dies anhand einer Platte mit rechteckiger Oberfläche schematisch gezeigt. Schraffiert sind Platte mit Ausformungen und Halterung mit Einfomungen. Die gezeigten Geraden gehen durch den Plattenschwerpunkt und zeigen am Plattenrand die definitionsgemäss radiale Richtung an. Bei der Figur wird auch deutlich, dass die Spaltbreite S nicht überall am Plattenrand gleich sein muss, sondern von der Geometrie abhängig gewählt werden kann.

Gemäss der vorliegenden Erfindung werden alle Spaltbreiten zwischen Plattenrand und innerer Halterungsberandung, einschliesslich Spaltbreiten zwischen Einformungen und Ausformungen, unter Berücksichtigung des Ausmasses und des thermischen Expansionskoeffizienten der Platte und der Halterung derart ausgewählt, dass die Platte sich innerhalb der Halterung bei höheren Temperaturen frei ausdehnen kann. Da die Wärmeausdehnung vor allem bei den festen Körpern stark von der Gitterstruktur bzw. den Bindungsverhältnissen abhängt, stellen die linearen Gleichungen nur Näherungen.

Der Ausdehnungskoeffizient oder Wärmeausdehnungskoeffizient ist ein Kennwert, der das Verhalten eines Stoffes bezüglich Veränderungen seiner Abmessungen bei Temperaturveränderungen beschreibt - deswegen oft auch thermischer Ausdehnungskoeffizient genannt. Der hierfür verantwortliche Effekt ist die Wärmeausdehnung. Die Wärmeausdehnung ist abhängig vom verwendeten Stoff, es handelt sich also um eine stoffspezifische Materialkonstante. Da die Wärmeausdehnung bei vielen Stoffen nicht gleichmäßig über alle Temperaturbereiche erfolgt, ist auch der Wärmeausdehnungskoeffizient selbst temperaturabhängig und wird deshalb für eine bestimmte Bezugstemperatur oder einen bestimmten Temperaturbereich angegeben.

Es wird zwischen dem thermischen Längenausdehnungskoeffizienten a (auch linearer Wärmeausdehnungskoeffizient) und dem thermischen Raumausdehnungskoeffizienten γ (auch räumlicher Ausdehnungskoeffizient oder Volumenausdehnungskoeffizient oder kubischer Ausdehnungskoeffizient) unterschieden.

Der Längenausdehnungskoeffizient α ist die Proportionalitätskonstante zwischen der Temperaturänderung dT und der relativen Längenänderung dL/L eines Festkörpers. Mit ihm wird demnach die relative Längenänderung bei einer Temperaturänderung beschrieben. Er ist eine stoffspezifische Grösse, die die Einheit K⁻¹ (pro Kelvin) hat und über die folgende Gleichung definiert ist: α=1/L·dl/dT, vereinfacht wäre die Gleichung L_{final} ≈ Lᵢₙᵢₜᵢₐₗ·(1 + α·ΔT).

Man könnte dann beispielweise berechnen, welche Länge die Platte in einer bestimmten Richtung der Plattenoberfläche bei einer maximalen Einsatztemperatur hätte. In ähnlicher Weise könnte man die Dimensionen nach der Wärmeausdehnung der Halterung berechnen. Somit kann man berechnen, welche Spaltenbereiten zwischen der Platte und der Halterung nötig sind, um die freie Wärmeausdehnung der Platte in der Halterung bis zur maximalen Einsatztemperatur sicherzustellen.

Beispielweise unter Annahme, dass L_{1final} ≈ α₁·L₁ᵢₙᵢₜᵢₐₗ·ΔT₁, wobei L_{1final} die Länge der Platte in einer bestimmten Richtung ist (im Fall einer scheibenförmigen Platte dann der Durchmesser), bei einer Temperatur T_{final} ist (beispielweise bei der maximalen Einsatztemperatur der Platte), α₁ der lineare Wärmeausdehnungskoeffizient der Platte bei dem Temperatureinsatzbereich ist, L₁ᵢₙᵢₜᵢₐₗ die Länge der Platte in der gleichen Richtung aber einer Temperatur Tᵢₙᵢₜᵢₐₗ ist (beispielweise bei Raumtemperatur), und in ähnlicher Weise für die Berechnung der Dimensionen der Halterung bei T_{final} aber unter Berücksichtigung der Form und Dimensionen der Halterung und des linearen Wärmeausdehnungskoeffizienten des Halterungsmaterials.

Vorzugsweise werden die Spaltbreiten zwischen der Platte und der Halterung so ausgewählt, dass die Platte sich innerhalb der Halterung bis zu einer Temperatur von mindestens 450 °C frei ausdehnen kann, vorzugsweise bis mindestens 500 °C, noch bevorzugt bis mindestens 650 °C.

Gemäss der vorliegenden Erfindung ist der lineare Wärmeausdehnungskoeffizient des Plattenmaterials grösser als der lineare Wärmeausdehnungskoeffizient des Halterungsmaterials, d.h. α1>α2.

Vorzugsweise ist die Platte scheibenförmig.

Vorzugsweise werden die Einformungen und/oder Ausformungen in der Platte äquidistant voneinander verteilt.

Vorzugsweise ist die Halterung ringförmig oder umfasst einen ringförmigen Teil zur Aufnahme der Platte.

Gemäss einer weiteren bevorzugten Ausführungsform der vorliegenden Erfindung kann die Platte ein scheibenförmiges Target mit sternförmig angebrachten Führungen (Ausformungen), deren gemeinsame Achse im Targetzentrum liegt und die in entsprechende sternförmige Nuten (Einformungen) der Halterung ragen. Beispielsweise ist die Halterung ein Teil einer Kühlplatte-Vorrichtung. So wird das Target durch die erfindungsgemässe Target-Kühlplatte-Gestaltung temperaturunabhängig auf die Kühlplatte zentriert. Somit, im Fall der Verwendung eines Anodenrings um das Target herum, kann der Spalt zwischen Target und Anodenring konzentrisch bleiben bzw. erfindungsgemäss konzentrisch gehalten werden.

Dadurch werden Kurzschlüsse, die aufgrund eines unerwünschten Kontakts zwischen dem Target, das als Kathode betrieben wird, und dem Anodenring auftreten könnten, vermieden.

Auch dadurch bleibt die Auflagefläche zwischen Target und Targethalterung in der Kühlplattevorrichtung (bspw. zwischen Target und einem Targethaltering) konzentrisch und bei der Verwendung von Folienkühlplatten ergeben sich im Target gleichmässige Spannungen. Die Auflagefläche kann so minimiert werden.

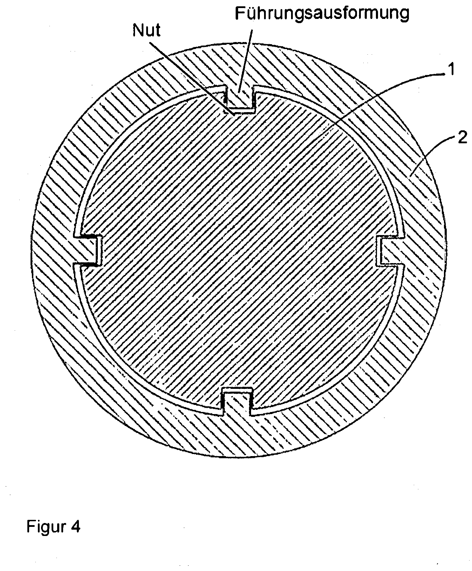

Anstatt Einformungen in der Kühlplatte vorzusehen, in welche Nasen (Ausformungen) vom Target hineinragen, ist es auch möglich, Einformungen im Target vorzusehen und den Aufnahmekörper der Kühlplatte-Vorrichtung, beispielweise den Targethaltering, mit nach innen ragenden Ausformungen auszuführen, welche in die Einformungen des Targets eingreifen, wie es in der Figur 4 gezeigt ist.

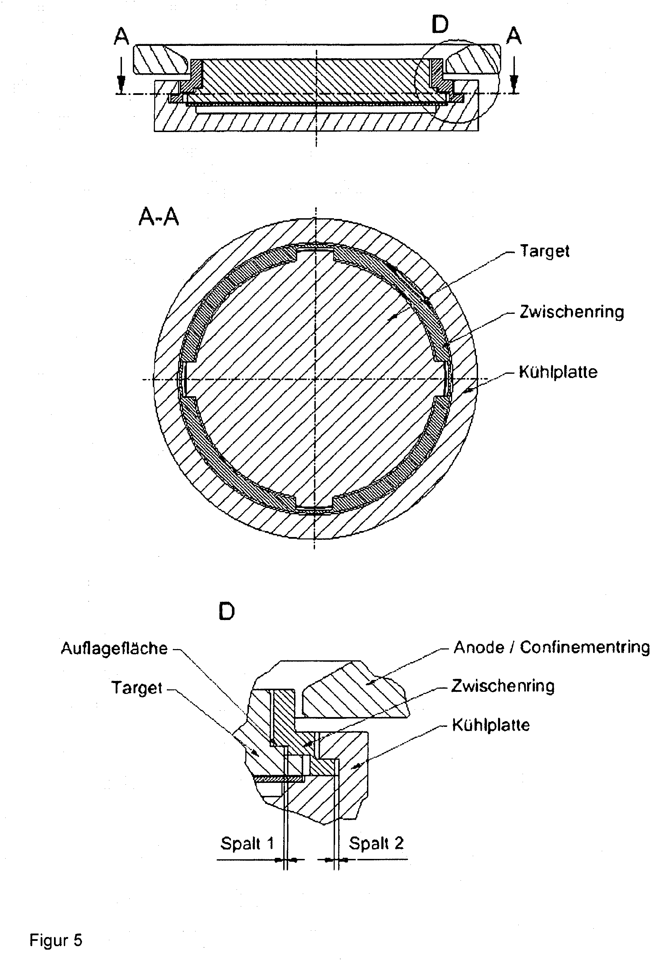

Ein besonderer Vorteil ergibt sich durch die Verwendung der vorliegenden Erfindung bei vorhandenen Kühlplatten, wobei ein zu geringer Spalt zwischen Target und Kühlplatte durch Einsatz eines Zwischenringes vergrössert werden kann. Wird das Target in einen Zwischenring und dieser dann auf die Kühlplatte montiert, so kann das gesamte Spiel (Spalt 1 und 2) zwischen Target und Kühlplatte und somit auch die eingebrachte Leistung vergrössert werden, wie es in der Figur 5 gezeigt wird.

Die Erfindung wird nun anhand der Figuren beispielhaft im Detail erläutert.
Figur 1 zeigt schematisch ein Target und eine Halterung.
Figur 2 zeigt eine Beschichtungsquelle mit Target, Kühlplatte und Anodenring.

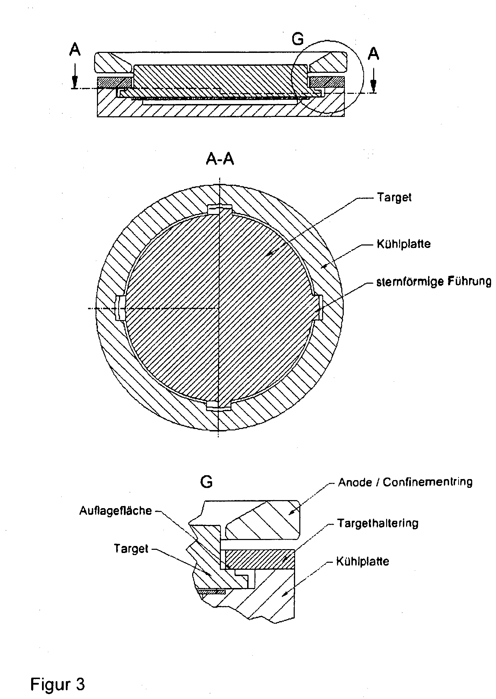

Figur 3 zeigt im Querschnitt, in der Draufsicht und Ausschnittsweise eine Ausführungsform der erfindungsgemässen Platte mit Halterung.
Figur 4 zeigt in Draufsicht eine Ausführungsform der erfindungsgemässen Platte mit Halterung.
Figur 5 zeigt einen Ausschnitt des Querschnittes einer Ausführungsform der vorliegenden Erfindung.

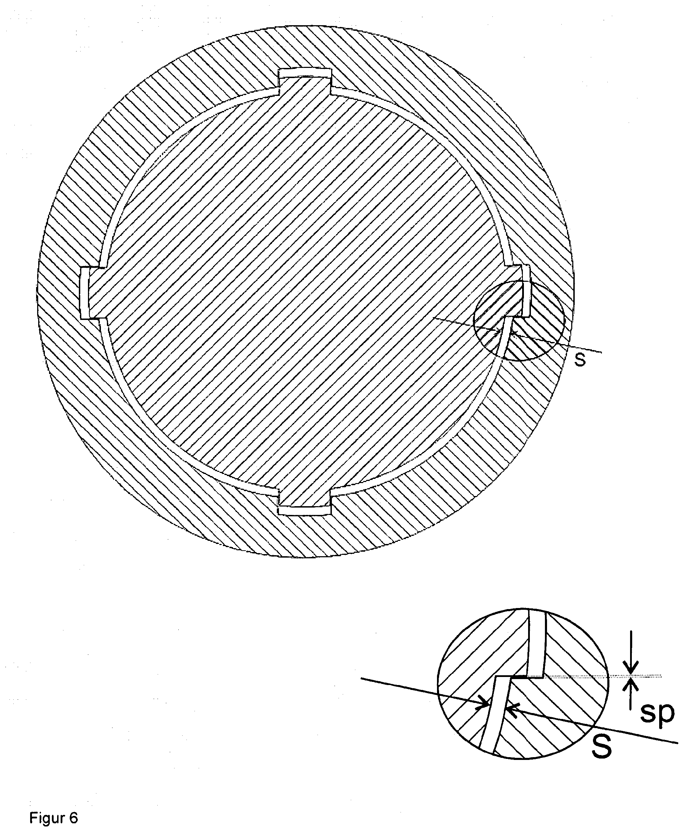

Figur 6 zeigt eine erfindungsgemässe Platte mit Halterung in Draufsicht sowie einen diesbezüglichen Ausschnitt.

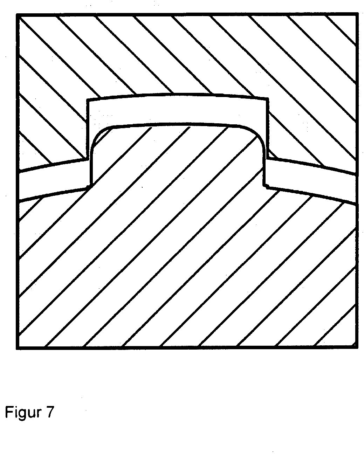

Figur 7 zeigt ein Einformungs-Ausformungspaar, wobei die Ausformung Abrundungen umfasst.
Figur 8 zeigt eine erfindungsgemässe Platte mit Halterung in Draufsicht, wobei die Platte eine rechteckige Oberfläche besitzt.

Es wurde eine scheibenförmige Platte mit Halterung offenbart, welche ein System "Platte-Halterung" bildet, wobei die Platte eine über weite Strecken ihres Umfangs kreisförmige Oberfläche mit einem äusseren Plattenrand aufweist und das Material der Platte einen ersten thermischen Expansionskoeffizienten, a1, besitzt und die Halterung eine über weite Strecken ihres Umfangs kreisförmige Öffnung aufweist, welche durch eine innere Halterungsberandung begrenzt ist und das Material der Halterung einen zweiten thermischen Expansionskoeffizienten, a2, besitzt und
- bei Raumtemperatur der Umfang der Öffnung der Halterung grösser ist als der Umfang der Oberfläche der Platte, wodurch bei zentrierter Position der Platte in der Öffnung der Halterung ein Spalt mit einer definierten Spaltbreite S zwischen Plattenrand und innerer Halterungsberandung vorliegt und
- α2< α1 ist und
- der Plattenrand eine oder mehrere Ausformungen umfasst, welche sich vom Mittelpunkt der kreisförmigen Oberfläche aus gesehen in radialer Richtung, ausgehend vom Plattenrand, über Ausformungslängen erstrecken und in korrespondierende Einformungen mit Einformungslängen der Halterungsberandung eingreifen und/oder der Plattenrand eine oder mehrere Einformungen umfasst, welche sich vom Plattenrand aus gesehen in Richtung Mittelpunkt der kreisförmigen Oberfläche über Einformungslängen erstrecken und korrespondierende Ausformungen mit Ausformungslängen der Halterungsberandung in diese eingreifen
- wobei das System "Platte - Halterung" zumindest drei solcher ineinander eingreifender Einformungs - Ausformungspaare umfasst und
wobei für die Einformungs-Ausformungspaare die entsprechenden radialen Längen aufeinander abgestimmt sind, dass bei Raumtemperatur in radialer Richtung die Einformungen jeweils höchstens bis auf einen radialen Abstand d in die Ausformung eingreifen, wobei die Grössenordnung des radialen Abstandes d der Grössenordnung der Spaltbreite S entspricht und
wobei für die Einformungs-Ausformungspaare in tangentialer Richtung die entsprechenden Breitenprofile so aufeinander abgestimmt sind, dass die Einformung für die korrespondierende Ausformung als Führungsschiene wirken kann, deren Spiel sp in tangentialer Richtung kleiner als S ist
und dadurch erreicht wird, dass sowohl bei Raumtemperatur als auch bei höheren Temperaturen, bei denen sich die Platte stärker ausdehnt als die Halterung, die sich ausdehnende Platte bis auf höchstens das Spiel sp immer zentriert in der Halterung verankert ist.

Für die oben beschriebene Platte mit Halterung kann vorzugsweise die Spaltbreite S, der radiale Abstand d und das Spiel sp so ausgewählt sein, dass die Platte sich innerhalb der Halterung bis zu einer Temperatur von mindestens 450 °C frei ausdehnen kann, vorzugsweise bis mindestens 500 °C, noch mehr bevorzugt bis mindestens 650 °C.

Für die oben beschriebene Platte mit Halterung können vorzugsweise die Einformungen und/oder Ausformungen in der Platte äquidistant voneinander verteilt sein.

Für die oben beschriebene Platte mit Halterung kann vorzugsweise die Halterung ringförmig sein oder einen ringförmigen Teil zur Aufnahme der Platte umfassen.

Für die oben beschriebene Platte mit Halterung sind vorzugsweise vier Einformungs-Ausformungspaare realisiert.

Im oben beschriebenen System Platte-Halterung kann die Platte ein Target zur Verwendung in einem PVD-Prozess sein und das System Platte-Halterung Teil einer dementsprechenden Beschichtungsquelle bilden.

An der oben beschriebenen Beschichtungsquelle können Mittel zum Anschluss einer Spannungsquelle vorgesehen sein, die es ermöglichen, das Target gegenüber einer Elektrode auf negatives Potential zu legen, sodass das Target als Kathode verwendet und die Elektrode als Anode verwendet werden kann.

Bei der oben beschriebenen Beschichtungsquelle können Teile der Halterung zumindest einen Teil einer Kühl-Vorrichtung bilden.

Die oben beschriebene Halterung kann als Zwischenring ausgestaltet sein.

Die Kühl-Vorrichtung kann vorzugsweise eine Vorrichtung des Typs Folienkühlplatte sein.

Die oben erwähnte Anode kann vorzugsweise um das Target herum platziert und als Anodenring ausgestaltet sein.

Bei der oben beschriebenen Platte mit Halterung kann vorzugsweise das Spiel sp höchstens halb so gross wie die Spaltbreite S sein und besonders bevorzugt eine Grössenordnung kleiner sein als die Spaltbreite S.

Bei der oben beschriebenen Platte mit Halterung weist das Breitenprofil in den Führungsbereichen zumindest einer der Ausformungen, vorzugsweise mehrerer Ausformungen und besonders bevorzugt aller Ausformungen in axialer Richtung i) keine Kanten auf, wodurch eine Verklemmung in der durch die entsprechende Einformung gegebenen Führungsschiene verunmöglicht wird oder das Breitenprofil umfasst ii) zumindest in dem radialen Teilabschnitt, in dem die Einformung geführt wird, parallele geradlinige Wände.

Bei der oben beschriebenen Platte mit Halterung kann dass das Breitenprofil zumindest einer Einformung, vorzugsweise mehrerer Einformungen, besonders bevorzugt aller Einformungen zumindest in dem radialen Teilabschnitt, in dem die Einformung die Führungsfunktion übernimmt i) parallele geradlinige Wände umfassen oder ii) keine Kanten aufweisen, wodurch eine Verklemmung mit der entsprechenden Ausformung in der durch die Einformung gegebene Führungsschiene verunmöglicht wird.

Vorzugsweise sind bei einem, mehreren oder allen Einformungs-Ausformungspaaren entweder die oben beschriebenen Alternativen i) gleichzeitig erfüllt oder die oben beschriebenen Alternativen ii) gleichzeitig erfüllt.

Es wurde eine PVD-Anlage mit zumindest einer Beschichtungsquelle wie oben beschrieben offenbart.

## Patentansprüche

1. Scheibenförmige Platte mit Halterung, welche ein System "Platte-Halterung" bilden, wobei die Platte eine über weite Strecken ihres Umfangs kreisförmige Oberfläche mit einem äusseren Plattenrand aufweist und das Material der Platte einen ersten thermischen Expansionskoeffizienten, a1, besitzt und die Halterung eine über weite Strecken ihres Umfangs kreisförmige Öffnung aufweist, welche durch eine innere Halterungsberandung begrenzt ist und das Material der Halterung einen zweiten thermischen Expansionskoeffizienten, a2, besitzt, **dadurch gekennzeichnet, dass**
- bei Raumtemperatur der Umfang der Öffnung der Halterung grösser ist als der Umfang der Oberfläche der Platte, wodurch bei zentrierter Position der Platte in der Öffnung der Halterung ein Spalt mit einer definierten Spaltbreite S zwischen Plattenrand und innerer Halterungsberandung vorliegt und
- α2< α1 ist und
- der Plattenrand eine oder mehrere Ausformungen umfasst, welche sich vom Mittelpunkt der kreisförmigen Oberfläche aus gesehen in radialer Richtung, ausgehend von der Plattenrandoberfläche, über Ausformungslängen erstrecken und in korrespondierende Einformungen mit Einformungslängen der Halterungsberandung eingreifen und/oder der Plattenrand eine oder mehrere Einformungen umfasst, welche sich vom Plattenrand aus gesehen in Richtung Mittelpunkt der kreisförmigen Oberfläche über Einformungslängen erstrecken und korrespondierende Ausformungen mit Ausformungslängen der Halterungsberandung in diese eingreifen
- wobei das System "Platte - Halterung" zumindest drei solcher ineinander eingreifenden Einformungs - Ausformungspaare umfasst und
- wobei für die Einformungs-Ausformungspaare die Längen so gewählt sind, dass bei Raumtemperatur in radialer Richtung die Einformungen jeweils höchstens bis auf einen radialen Abstand d in die Ausformung eingreifen, dessen Grössenordnung derjenigen der Spaltbreite S entspricht und
- und wobei für die Einformungs-Ausformungspaare in tangentialer Richtung die Breitenprofile so aufeinander abgestimmt sind, dass die Einformung für die korrespondierende Ausformung als Führungsschiene wirken kann, deren Spiel sp in tangentialer Richtung kleiner als S ist
und dadurch erreicht wird, dass sowohl bei Raumtemperatur als auch bei höheren Temperaturen, bei denen sich die Platte stärker ausdehnt als die Halterung, die sich ausdehnende Platte bis auf höchstens das Spiel sp immer zentriert in der Halterung verankert ist,
wobei das Breitenprofil in den Führungsbereichen zumindest einer der Ausformungen, vorzugsweise mehrerer Ausformungen und besonders bevorzugt aller Ausformungen in axialer Richtung i) keine Kanten aufweist, wodurch eine Verklemmung in der durch die entsprechende Einformung gegebene Führungsschiene verunmöglicht wird oder ii) zumindest in dem radialen Teilabschnitt, in dem die Einformung geführt wird, parallele geradlinige Wände umfasst.

2. Scheibenförmige Platte mit Halterung nach Anspruch 1, **dadurch gekennzeichnet, dass** das Breitenprofil zumindest einer Einformung, vorzugsweise mehrerer Einformungen, besonders bevorzugt aller Einformungen zumindest in dem radialen Teilabschnitt, in dem die Einformung die Führungsfunktion übernimmt, i) parallele geradlinige Wände umfasst oder ii) keine Kanten aufweist, wodurch eine Verklemmung in der durch die entsprechende Einformung gegebenen Führungsschiene verunmöglicht wird.

3. Scheibenförmige Platte mit Halterung nach mindestens einem der vorangehenden Ansprüche 1 bis 2, **dadurch gekennzeichnet, dass** für ein Einformungs-Ausformungspaar, vorzugsweise für mehrere und besonders bevorzugt für alle die Alternative i) der Ansprüche 1 und 2 oder die Alternative ii) der Ansprüche 1 und 2 verwirklicht ist.

4. Scheibenförmige Platte mit Halterung nach einem der vorangehenden Ansprüche 1 bis 3, wobei die Spaltbreite S, der radiale Abstand d und das Spiel sp so ausgewählt sind, dass die Platte sich innerhalb der Halterung bis zu einer Temperatur von mindestens 450 °C frei ausdehnen kann, vorzugsweise bis mindestens 500 °C, noch mehr bevorzugt bis mindestens 650 °C.

5. Scheibenförmige Platte mit Halterung nach mindestens einem der vorangehenden Ansprüche 1 bis 4, wobei die Einformungen und/oder Ausformungen in der Platte äquidistant voneinander verteilt sind.

6. Scheibenförmige Platte mit Halterung nach mindestens einem der vorhergehenden Ansprüche 1 bis 5, wobei die Halterung ringförmig ist oder einen ringförmigen Teil zur Aufnahme der Platte umfasst.

7. Scheibenförmige Platte mit Halterung nach mindestens einem der vorhergehenden Ansprüche 1 bis 6, wobei vier Einformungs-Ausformungspaare realisiert sind.

8. Scheibenförmige Platte mit Halterung nach mindestens einem der vorhergehenden Ansprüche 1 bis 7, wobei das Spiel sp höchstens halb so gross wie die Spaltbreite S ist und vorzugsweise eine Grössenordnung kleiner als die Spaltbreite S ist.

9. Scheibenförmige Platte mit Halterung nach mindestens einem der vorhergehenden Ansprüche 1 bis 8, wobei die Platte ein Target zur Verwendung in einem PVD-Prozess ist und das System Platte-Halterung Teil einer dementsprechenden Beschichtungsquelle ist.

10. Scheibenförmige Platte mit Halterung nach Anspruch 9, wobei an der Beschichtungsquelle Mittel zum Anschluss einer Spannungsquelle vorgesehen sind, die es ermöglichen, das Target gegenüber einer Elektrode auf negatives Potential zu legen, sodass das Target als Kathode und die Elektrode als Anode verwendet werden kann.

11. Scheibenförmige Platte mit Halterung nach mindestens einem der Ansprüche 9 bis 10, wobei zumindest Teile der Halterung zumindest einen Teil einer Kühl-Vorrichtung bilden.

12. Scheibenförmige Platte mit Halterung nach Anspruch 11, wobei die Halterung als Zwischenring ausgestaltet ist.

13. Scheibenförmige Platte mit Halterung nach mindestens einem der Ansprüche 11 bis 12, wobei die Kühl-Vorrichtung eine Vorrichtung des Typs Folienkühlplatte ist.

14. Scheibenförmige Platte mit Halterung nach mindestens einem der vorhergehenden Ansprüche 10 bis 13, wobei die Anode um das Target herum platziert und als Anodenring ausgestaltet ist.

15. PVD-Anlage mit zumindest einer Beschichtungsquelle mit einer scheibenförmigen Platte mit Halterung gemäss einem der Ansprüche 9 bis 14.

## Claims

1. A disc-shaped plate with a holder, which form a system "plate-holder",
wherein the plate has a surface that is circular over large sections of its circumference with an outer plate edge, and the material of the plate has a first thermal expansion coefficient α1, and the holder has an opening that is circular over large sections of its circumference and is delimited by an inner holder edge, and the material of the holder has a second thermal expansion coefficient a2, **characterized in that**,
- at room temperature, the circumference of the opening of the holder is greater than the circumference of the surface of the plate, whereby, when the plate is positioned centrally in the opening of the holder, a gap with a defined gap width S between the plate edge and the inner holder edge is provided, and
- α2<α1, and
- the plate edge has one or more protrusions, which, viewed from the center point of the circular surface, extend over protrusion lengths in a radial direction starting from the surface of the plate edge and reach into corresponding recesses with recess lengths of the holder edge, and/or the plate edge has one or more recesses, which, viewed from the plate edge, extend over recess lengths toward the center point of the circular surface, and corresponding protrusions of the holder edge with protrusion lengths reach into them,
- wherein the system "plate-holder" comprises at least three such meshing recess/protrusion pairs, and
- wherein, for the recess/protrusion pairs, the lengths are selected in such a way that at room temperature, the recesses reach radially into the protrusions, in each case at most up to a radial spacing d, whose order of magnitude corresponds to that of the gap width S, and
- and wherein for the recess/protrusion pairs, the width profiles are matched to each other, in the tangential direction, in such a way the recess can act as a guide rail, whose clearance sp in the tangential direction is less than S, for the corresponding protrusion
and it is thus achieved that, both at room temperature and at higher temperatures, at which the plate expands more than the holder, the expanding plate is always anchored centrally in the holder, apart from, at most, the clearance sp,
wherein the width profile in the guide regions of at least one of the protrusions, preferably of several protrusions, and particularly preferably of all protrusions, in the axial direction, i) has no edges, whereby jamming in the guide rail provided by the corresponding recess is made impossible, or ii) has parallel, straight walls at least in the radial subsection in which the recess is guided.

2. The disc-shaped plate with a holder according to claim 1, **characterized in that** the width profile of at least one recess, preferably of several recesses, and particularly preferably of all recesses, at least in the radial subsection in which the recess fulfils the guiding function, i) has parallel, straight walls, or ii) has no edges, whereby jamming in the guide rail provided by the corresponding recess is made impossible.

3. The disc-shaped plate with a holder according to at least one of the preceding claims 1 to 2, **characterized in that** the alternative i) of the claims 1 and 2 or the alternative ii) of the claims 1 and 2 is realized for one recess/protrusion-pair, preferably for several, and particularly preferably for all.

4. The disc-shaped plate with a holder according to any one of the preceding claims 1 to 3, wherein the gap width S, the radial spacing d, and the clearance sp are selected so that the plate can freely expand inside the holder up to a temperature of at least 450° C, preferably up to at least 500°C, more preferably up to at least 650°C.

5. The disc-shaped plate with a holder according to at least one of the preceding claims 1 to 4, wherein the recesses and/or protrusions in the plate are distributed equidistantly from one another.

6. The disc-shaped plate with a holder according to at least one of the preceding claims 1 to 5, wherein the holder is annular or comprises an annular part for accommodating the plate.

7. The disc-shaped plate with a holder according to at least one of the preceding claims 1 to 6, wherein four recess/protrusion-pairs are realized.

8. The disc-shaped plate with a holder according to at least one of the preceding claims 1 to 7, wherein the clearance sp is at most half as big as the gap width S and preferably one order of magnitude smaller than the gap width S.

9. The disc-shaped plate with a holder according to at least one of the preceding claims 1 to 8, wherein the plate is a target for use in a PVD process and the system "plate-holder" is part of a corresponding coating source.

10. The disc-shaped plate with a holder according to claim 9, wherein means for connecting a voltage source are provided on the coating source, which make it possible to set the target to a negative potential with respect to an electrode, so that the target can be used as a cathode and the electrode as an anode.

11. The disc-shaped plate with a holder according to at least one of the claims 9 to 10, wherein at least parts of the holder form at least a part of a cooling device.

12. The disc-shaped plate with a holder according to claim 11, wherein the holder is configured as an intermediate ring.

13. The disc-shaped plate with a holder according to at least one of the claims 11 to 12, wherein the cooling device is a device of the foil cooling plate type.

14. The disc-shaped plate with a holder according to at least one of the preceding claims 10 to 13, wherein the anode is placed around the target and configured as an anode ring.

15. A PVD system comprising at least one coating source with a disc-shaped plate with a holder according to any one of the claims 9 to 14.

## Revendications

1. Plaque en forme de disque avec support, qui constituent un système "plaque-support", la plaque présentant une surface qui est de forme circulaire sur de grandes extensions de sa périphérie et qui présente un bord de plaque extérieur, le matériau de la plaque possédant un premier coefficient d'expansion thermique α1, le support présentant une ouverture circulaire sur de grandes extensions de sa périphérie, ladite ouverture étant délimitée par un rebord intérieur du support, et le matériau du support possédant un second coefficient d'expansion thermique a2,
**caractérisée en ce que**
- à température ambiante, la périphérie de l'ouverture du support est supérieure à la périphérie de la surface de la plaque, moyennant quoi, en position centrée de la plaque dans l'ouverture du support, un intervalle ayant une largeur d'intervalle définie S existe entre le bord de la plaque et le rebord intérieur du support, et
- α2 < α1, et
- le bord de la plaque présente une ou plusieurs saillies qui, vues depuis le centre de la surface circulaire, s'étendent en direction radiale à partir de la surface de bord de la plaque sur des longueurs de saillie et s'engagent dans des retraits correspondants, ayant des longueurs de retrait, du rebord du support, et/ou le bord de la plaque présente un ou plusieurs retraits qui, vus depuis le bord de la plaque, s'étendent en direction du centre de la surface circulaire sur des longueurs de retrait, dans lesquels s'engagent des saillies correspondantes, ayant des longueurs de saillie, du rebord du support,
- le système "plaque-support" comprend au moins trois de ces appariements retrait - saillie en engagement mutuel, et
- les longueurs des appariements retrait - saillie sont choisies de telle sorte qu'à température ambiante les saillies s'engagent chacune au maximum jusqu'à une distance radiale d dans les retraits, en direction radiale, distance dont l'ordre de grandeur correspond à celui de la largeur d'intervalle S, et
- les profils en largeur des appariements retrait - saillie sont adaptés mutuellement en direction tangentielle de telle sorte que le retrait peut faire office de rail de guidage pour la saillie correspondante, dont le jeu sp en direction tangentielle est inférieur à S,
moyennant quoi aussi bien à température ambiante qu'à des températures plus élevées auxquelles la plaque se dilate plus fortement que le support, la plaque en dilatation est toujours ancrée de façon centrée dans le support, au maximum au jeu sp près,
le profil en largeur dans les zones de guidage de l'une au moins des saillies, de préférence de plusieurs saillies et de manière particulièrement préférée de toutes les saillies, i) ne présente pas d'arêtes en direction axiale, rendant impossible un coincement dans le rail de guidage défini par le retrait correspondant, ou ii) présente des parois rectilignes parallèles au moins dans la portion partielle radiale dans laquelle est prévu le retrait.

2. Plaque en forme de disque avec support selon la revendication 1,
**caractérisée en ce que**
au moins dans la portion partielle radiale dans laquelle le retrait fait office de guidage, le profil en largeur d'au moins un retrait, de préférence de plusieurs retraits, de manière particulièrement préférée de tous les retraits, i) présente des parois rectilignes parallèles ou ii) ne présente pas d'arêtes, moyennant quoi un coincement dans le rail de guidage défini par le retrait correspondant est rendu impossible.

3. Plaque en forme de disque avec support selon l'une au moins des revendications précédentes 1 à 2,
**caractérisée en ce que**
pour un appariement retrait-saillie, de préférence pour plusieurs et de manière particulièrement préférée pour tous les appariements retrait-saillie, la variante i) des revendications 1 et 2 ou la variante ii) des revendications 1 et 2 est réalisée.

4. Plaque en forme de disque avec support selon l'une des revendications précédentes 1 à 3,
dans laquelle
la largeur d'intervalle S, la distance radiale d et le jeu sp sont choisis de telle sorte que la plaque peut se dilater librement à l'intérieur du support jusqu'à une température d'au moins 450 °C, de préférence d'au moins 500 °C, de manière particulièrement préférée d'au moins 650 °C.

5. Plaque en forme de disque avec support selon l'une au moins des revendications précédentes 1 à 4,
dans laquelle
les retraits et/ou les saillies dans la plaque sont répartis de façon équidistante les un(e)s par rapport aux autres.

6. Plaque en forme de disque avec support selon l'une au moins des revendications précédentes 1 à 5,
dans laquelle
le support est de forme annulaire ou comprend une partie annulaire pour recevoir la plaque.

7. Plaque en forme de disque avec support selon l'une au moins des revendications précédentes 1 à 6,
dans laquelle
quatre appariements retrait - saillie sont réalisés.

8. Plaque en forme de disque avec support selon l'une au moins des revendications précédentes 1 à 7,
dans laquelle
le jeu sp est au maximum de la moitié de la largeur d'intervalle S et de préférence inférieur d'un ordre de grandeur à la largeur d'intervalle S.

9. Plaque en forme de disque avec support selon l'une au moins des revendications précédentes 1 à 8,
dans laquelle
la plaque est une cible destinée à l'utilisation dans un processus PVD, et le système plaque-support fait partie d'une source de revêtement correspondante.

10. Plaque en forme de disque avec support selon la revendication 9,
dans laquelle
des moyens de connexion d'une source de tension sont prévus sur la source de revêtement, qui permettent de mettre la cible à un potentiel négatif par rapport à une électrode, de sorte que la cible peut servir de cathode et l'électrode peut servir d'anode.

11. Plaque en forme de disque avec support selon l'une au moins des revendications 9 à 10,
dans laquelle
des parties au moins du support constituent une partie au moins d'un dispositif de refroidissement.

12. Plaque en forme de disque avec support selon la revendication 11,
dans laquelle
le support est conçu sous forme d'anneau intermédiaire.

13. Plaque en forme de disque avec support selon l'une au moins des revendications 11 à 12,
dans laquelle
le dispositif de refroidissement est un dispositif de type plaque de refroidissement à feuille.

14. Plaque en forme de disque avec support selon l'une au moins des revendications 10 à 13,
dans laquelle
l'anode est placée autour de la cible et est conçue sous forme d'anneau d'anode.

15. Installation PVD comportant au moins une source de revêtement ayant une plaque en forme de disque avec support selon l'une des revendications 9 à 14.
